# EUROPÄISCHE PATENTSCHRIFT

(11) **EP 0 811 707 B1**
(45) Veröffentlichungstag und Bekanntmachung des Hinweises auf die Patenterteilung: **31.10.2001**
(21) Anmeldenummer: 97108701.0
(22) Anmeldetag: 30.05.1997
(51) Int. Cl.: C30B 15/00, C30B 15/14, C30B 29/06

(54) **Verfahren und Vorrichtung zur Herstellung von Einkristallen**
Process and apparatus for making single crystals
Procédé et appareillage pour la fabrication de monocristaux

(30) Priorität: 05.06.1996 DE 19622664
(43) Veröffentlichungstag der Anmeldung: 10.12.1997
(73) Patentinhaber: Wacker Siltronic Gesellschaft für Halbleitermaterialien Aktiengesellschaft, 84489 Burghausen (DE)
(72) Erfinder: Dornberger, Erich, 84489 Burghausen (DE); Ölkrug, Hans, Dr., 84529 Tittmoning (DE); von Ammon, Wilfried, Dr., 84489 Burghausen (DE); Gräf, Dieter, Dr., 84489 Burghausen (DE)
(74) Vertreter: Rimböck, Karl-Heinz, Dr.

(56) Entgegenhaltungen:
- EP-A- 0 229 322
- EP-A- 0 504 837
- EP-A- 0 591 525
- EP-A- 0 612 867
- EP-A- 0 903 427
- DE-A- 3 905 626
- US-A- 4 597 949
- PATENT ABSTRACTS OF JAPAN vol. 18, no. 163 (C-1181), 18.März 1994 & JP 05 330975 A (MITSUBISHI MATERIALS CORP.)
- PATENT ABSTRACTS OF JAPAN vol. 15, no. 377 (C-870), 24.September 1991 & JP 03 153595 A (OSAKA TITANIUM CO. LTD.)

## Beschreibung

Gegenstand der Erfindung ist ein Verfahren zur Herstellung von Einkristallen aus Silicium mit einer bestimmten Defektdichte. Gegenstand der Erfindung ist auch eine Vorrichtung zur Durchführung des Verfahrens.

Die Herstellung von Einkristallen aus Silicium erfolgt in den überwiegend praktizierten Fällen in einem Tiegelzieh-Verfahren (Czochralski-Verfahren oder CZ-Methode genannt) oder einem tiegelfreien Ziehverfahren (Zonenschmelz-Verfahren oder FZ-Methode genannt). Die stangenförmigen Einkristalle mit Durchmessern von typischerweise 100 bis 300 mm dienen vornehmlich als Grundmaterial zur Herstellung von Scheiben ("wafer"), aus denen wiederum elektronische Bauelemente gefertigt werden. Bei einer genaueren Untersuchung der Einkristalle und der Scheiben findet man Defekte von unterschiedlicher Art und Größe und in unterschiedlicher Dichte (Anzahl pro Raum- oder Flächeneinheit), die beim Ziehen des Einkristalls entstanden sind.

Im Zusammenhang mit der vorliegenden Erfindung sind zunächst die Flow-Pattern-Defekte (nachfolgend mit "FPD" abgekürzt) zu nennen. Diese können als Ätzpunkte mit keilförmigen Ätzfahnen nach 30 min Secco-Ätze (H.Yamagishi, I.Fusegawa, N.Fujimaki and M.Katayama, Semicond. Sci. Technol.7 (1992) A 135) sichtbar gemacht werden. Die FPD-Dichte beeinflußt unmittelbar die Durchschlagsfestigkeit eines, auf einer Silicium-Scheibe erzeugten Oxid-Films. Ein wichtiger Kennwert für die Beurteilung der Durchschlagsfestigkeit ist die sogenannte GOI-Ausbeute ("gate oxide integrity"). Bei hohen FPD-Dichten sind die GOI-Ausbeuten niedrig. Scheiben, die für die Herstellung elektronischer Bauelemente vorgesehen sind ("prime-wafer"), sollten möglichst hohe GOI-Ausbeuten aufweisen, weil die Ausbeute an funktionstüchtigen Bauelementen auch von hohen GOI-Ausbeuten abhängt. Allerdings ist die GOI-Ausbeute für Test-Scheiben ("monitor-wafer"), die nicht zur Herstellung elektronischer Bauelemente, sondern nur zur Überprüfung der Prozesse der

Bauelementherstellung verwendet werden, von eher untergeordneter Bedeutung.

In der EP-504 837 A2 ist offenbart, daß Verweilzeiten des wachsenden Einkristalls bei Temperaturen von über 1150 °C einen günstigen Einfluß auf die GOI-Ausbeute haben.

Gemäß der deutschen Offenlegungsschrift DE 39 05 626 A1 ist die Verweilzeit beim Ziehen eines Einkristalls aus Silicium in einem Temperaturbereich zwischen 1050 und 850°C auf nicht länger als 140 min festzusetzen.

Zu einer anderen Defekt-Klasse gehören die Lichtpunktdefekte (nachfolgend mit "LPD" abgekürzt), die an polierten Scheibenoberflächen mit optischen Meßgeräten erfaßt werden können. Wenn sich Lichtpunktdefekte in hoher Dichte nachweisen lassen, so gelten die betroffenen Scheiben sowohl für eine Verwendung als prime-wafer als auch für eine Verwendung als monitor-wafer als minderwertig, es sei denn, die Größe der LPD liegt überwiegend in einem Bereich von unter 0,12µm. In diesem Fall ist eine Verwendung der Scheiben als monitor-wafer durchaus möglich, da die Defekte nicht schädlich sind, weil ihre Größe unter der derzeit üblichen Linienbreite von Bauelementstrukturen liegt. Darüber hinaus läßt sich die Zahl dieser LPD durch eine besondere Temperaturbehandlung (annealing) stark reduzieren und gleichzeitig die GOI-Ausbeute erhöhen, so daß sich derartig behandelte Scheiben auch als prime-wafer eignen.

Die vorliegende Erfindung löst die Aufgabe, die Herstellung von Einkristallen aus Silicium so zu verbessern, daß Scheiben, die von einem gezogenen Einkristall abgetrennt werden, eine besonders hohe GOI-Ausbeute zeigen und sich daher besonders gut als prime-wafer eignen.

Gegenstand der Erfindung ist ein Verfahren zur Herstellung eines Einkristalls aus Silicium, wobei der wachsende Einkristall während einer bestimmten Verweildauer in einem bestimmten Temperaturbereich gehalten wird, das dadurch gekennzeichnet ist, daß als Temperaturbereich der Bereich von 850 bis 1100 °C gewählt wird und die Verweildauer des wachsenden Einkristalls in dem gewählten Temperaturbereich größer als 250 min ist.

Besonders bevorzugt ist, daß als Temperaturbereich der Bereich von 900 bis 1050 °C gewählt wird.

Ist die Verweildauer des wachsenden Einkristalls im Temperaturbereich von 850 bis 1100 °C größer als 250 min, weisen die vom Einkristall abgetrennten Silicium-Scheiben sehr geringe FPD-Dichten und sehr hohe GOI-Ausbeuten auf. Sie eignen sich daher bestens als prime-wafer.

Die Einstellung der Verweildauer ist maßgeblich durch die Ziehgeschwindigkeit und die thermische Abschirmung des wachsenden Einkristalls beeinflußbar. Je höher die Ziehgeschwindigkeit ist, desto kürzer wird die Verweildauer des wachsenden Einkristalls in einem bestimmten Temperaturbereich. Die Geschwindigkeit, mit der der wachsende Einkristall abkühlt, hängt maßgeblich von der thermischen Abschirmung des Einkristalls ab, wobei die Abschirmung von einer Heizungsquelle, beispielsweise einer Tiegelheizung, besonders zu beachten ist. Vom Ziehen von Einkristallen aus Silicium nach der CZ-Methode sind Hitzeschilde in verschiedenen Ausführungen bekannt, die verwendet werden, um den wachsenden Einkristall thermisch abzuschirmen. Je wärmedurchlässiger (transparenter) der Hitzeschild für Wärmestrahlung und Wärmeleitung ist, desto langsamer kühlt ein gewachsener Abschnitt des Einkristalls ab und desto länger bleibt die Temperatur dieses Abschnitts in einem bestimmten Temperaturbereich. Die geeignete Abstimmung von Ziehgeschwindigkeit und thermischer Abschirmung des Einkristalls zum Erzielen der vorgesehenen Verweildauer im vorgesehenen Temperaturbereich wird durch vorhergehende Computersimulationen und Vorversuche erleichtert. Ein geeignetes Simulationsprogramm läßt sich beispielsweise nach Modellrechnungen von Dupret et al. entwickeln. (Dupret et al., Int.J.Heat Mass Transfer, Vol.33, No.9, pp.1849-1871, 1990). Besonderes Augenmerk ist darauf zu legen, welche Werte der Hitzeschild in Bezug auf Wärmeleitfähigkeit und Durchlässigkeit von Wärmestrahlung aufweist. Bekannte Werkstoffe für Hitzeschilde sind beispielsweise Molybdänblech, Graphit und Graphitfilz. Einige Hitzeschilde sind schichtförmig aufgebaute Verbundkörper solcher Werkstoffe.

In der EP 903 427 A1 ist ein Hitzeschild offenbart, dessen Innendurchmesser an seinem unteren Ende größer ist als an seinem oberen Ende.

Die US-4,597,949 beschreibt ein um den Einkristall angeordnetes Rohr mit einem Heizer am unteren Ende.

Die Erfinder haben nun einen verbesserten Hitzeschild entwickelt, der besonders zur Durchführung des beanspruchten Verfahrens geeignet ist.

Gegenstand der Erfindung ist auch eine Vorrichtung zur Herstellung eines Einkristalls aus Silicium mit einem, den wachsenden Einkristall umgebenden Hitzeschild, die dadurch gekennzeichnet ist, daß der Hitzeschild zwischen einem unteren und einem oberen Rand in mindestens zwei ringförmige Zonen untergliedert ist, die von übereinander angeordneten Segmenten gebildet werden, wobei sich benachbarte Segmente in Bezug auf Wärmeleitfähigkeit und Durchlässigkeit von Wärmestrahlung alleine aufgrund ihrer Materialeigenschaft unterscheiden, und ein aktives Kühlen oder Erhitzen durch die Segmente selbst nicht vorgesehen ist.

Der verbesserte Hitzeschild ist immer dann von Vorteil, wenn der zeitliche Temperaturverlauf (die Temperatur-Historie) in einem bestimmten Abschnitt des wachsenden Einkristalls während des Ziehvorgangs beeinflußt werden soll.

Bekannte Hitzeschilde bestehen aus gleichartigem Material mit in Bezug auf Wärmeleitung und Durchlässigkeit von Wärmestrahlung einheitlichen Eigenschaften. Der erfindungsgemäße Hitzeschild ist in mindestens 2, vorzugsweise 2 bis 5, ringförmige Zonen untergliedert. Vom unteren Rand des Hitzeschilds beginnend folgt eine Zone der nächsten bis zum oberen Rand des Hitzeschilds. Besonderes Kennzeichen der Zonen ist, daß sich zwei benachbarte Zonen in Bezug auf Wärmeleitung und Durchlässigkeit von Wärmestrahlung unterscheiden. So ist beispielsweise eine wiederholte Abfolge von stark wärmeisolierenden und weniger stark wärmeisolierenden Zonen möglich, um bei konstanter Ziehgeschwindigkeit die Abkühlgeschwindigkeit des wachsenden Einkristalls entsprechend einer gewünschten Defektverteilung und Defektdichte einzustellen. Der erfindungsgemäße Hitzeschild ist aus ringförmigen Segmenten, die übereinander angeordnet sind, aufgebaut. Benachbarte Segmente bestehen aus Materialien, die sich in Bezug auf Wärmeleitung und Durchlässigkeit von Wärmestrahlung unterscheiden. Es ist auch nicht ausgeschlossen, daß zwei Segmente nur über Streben in Verbindung stehen, so daß der offene Zwischenraum zwischen den Segmenten als Zone mit besonders hoher Durchlässigkeit von Wärmestrahlung wirkt. Gegebenenfalls kann ein Segment durch Verwendung einer Kühl- oder Heizvorrichtung auch aktiv gekühlt oder erwärmt werden und eine Steuerung vorgesehen sein, mit der die Kühl- oder Heizleistung der Vorrichtung an die Erfordernisse der gewünschten Abkühlgeschwindigkeit des Einkristalls angepaßt wird.

Als besonders vorteilhaft hat sich der Hitzeschild für das Ziehen nach der CZ-Methode erwiesen, insbesondere, wenn mit Geschwindigkeiten von über 0,5 mm/min gezogen wird. Nach Feststellungen der Erfinder muß der radiale Temperaturgradient auf der Oberfläche der Schmelze um die Phasengrenze zwischen Einkristall und Schmelze herum möglichst hoch sein, damit der Einkristall zylindrisch wächst und sich keine, quer zur Wachstumsrichtung gerichteten, Auswölbungen bilden. Mit einer besonderen Ausführungsform des Hitzeschilds kann ein hoher radialer Temperaturgradient und damit ein stabiles Kristallwachstum auch bei Ziehgeschwindigkeiten gewährleistet werden, bei denen die Verwendung eines bekannten Hitzeschilds zu einem instabilen Kristallwachstum führen würde. Diese Ausführungsform ist dadurch gekennzeichnet, daß die Zone am unteren Rand des Hitzeschilds, die der Phasengrenze zwischen Einkristall und Schmelze am nächsten ist, einen Emissions-Koeffizienten von 0,3 bis 0,9 und einen Wärmeleitungs-Koeffizienten von 0,02 bis 5 Wm⁻¹K⁻¹ aufweist und daher besonders wärmeisolierend wirkt.

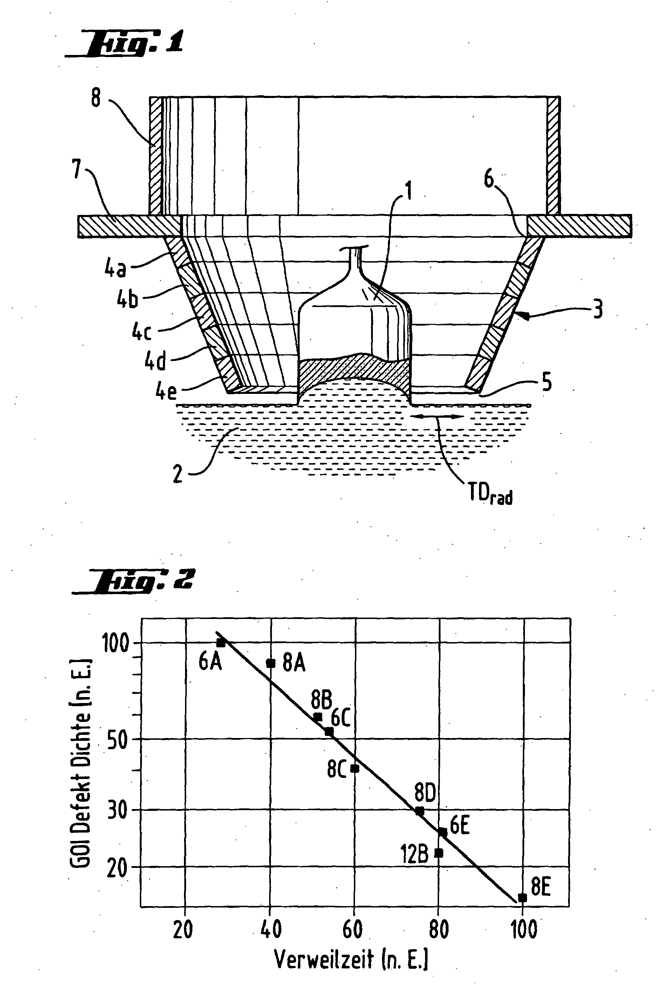

Die Erfindung wird nachfolgend an zwei Figuren näher erläutert. Figur 1 zeigt den schematischen Aufbau einer Ziehanlage zum Ziehen eines Einkristalls nach der CZ-Methode in Längsschnitt-Darstellung. Die Erfindung ist jedoch ebenso beim Einsatz der FZ-Methode verwertbar. Es sind nur die zum Verständnis der Erfindung wesentlichen Merkmale dargestellt, da der grundsätzliche Aufbau von Ziehanlagen zur Herstellung von Einkristallen sowohl nach der CZ-Mehtode als auch nach der FZ-Methode aus vielen Veröffentlichungen seit langem bekannt ist.

Die Figur 2 bezieht sich auf Ergebnisse eines später beschriebenen Beispiels und zeigt ein Diagramm, in dem die Dichte der GOI-Defekte in Abhängigkeit der Verweildauer des wachsenden Einkristalls im Temperaturbereich von 900 bis 1050 °C aufgetragen ist.

In Figur 1 kann man den wachsenden Einkristall 1 erkennen, der aus einer Schmelze 2 gezogen wird. Als besondere Merkmale der Vorrichtung sind nur ein Hitzeschild 3, eine Abdeckung 7 und eine Zusatzisolierung 8 dargestellt. Der Einkristall ist vom Hitzeschild 3 umgeben. An seinem oberen Rand 6 wird der Hitzeschild von der Abdeckung 7 gehalten, die den umgebenden Raum der Ziehanlage in einen unteren und in einen oberen Teil aufteilt. Mit dem Hitzeschild 3 und gegebenenfalls der Zusatzisolierung 8 im oberen Teil der Ziehanlage wird der Einkristall thermisch abgeschirmt. Mit der Zusatzisolierung kann, wie mit dem Hitzeschild, Einfluß auf die Temperatur-Historie beim Abkühlen des Einkristalls genommen werden. Gemäß der Erfindung ist der Hitzeschild zwischen dem unteren Rand 5 und dem oberen Rand 6 in ringförmige Zonen untergliedert, wobei benachbarte Zonen sich in Bezug auf Wärmeleitung und Durchlässigkeit von Wärmestrahlung unterscheiden. Der dargestellte Hitzeschild besteht aus fünf ringförmigen Segmenten 4a-4e, die übereinander angeordnet sind. Jedes Segment bildet gleichzeitig eine Zone mit bestimmter Wärmeleitfähigkeit und Durchlässsigkeit von Wärmestrahlung. Die Materialien für die Segmente werden vorzugsweise aus einer Gruppe ausgewählt, die Graphit, Graphitfilz, Quarz, Silicium, CFC, Molybdän, Silber und schichtförmige Verbundstrukturen zweier oder mehrerer der genannten Werkstoffe umfaßt.

Bevorzugt ist, daß das Segment am unteren Rand 5 des Hitzeschilds besonders wärmeisolierend wirkt, damit der als "DT_{rad}" gekennzeichnete radiale Temperaturgradient auf der Oberfläche der Schmelze um die Phasengrenze zwischen Einkristall und Schmelze herum möglichst hoch ist.

### Beispiel:

Es wurden Einkristalle aus Silicium mit Durchmessern von 150 mm bis 300 mm nach der CZ-Methode gezogen und zu Scheiben geteilt. Die Ziehgeschwindigkeit blieb während eines

Ziehvorgangs nahezu unverändert. Die Verweildauern der Einkristalle im Temperaturbereich von 900 bis 1050 °C waren unterschiedlich. Bei den erhaltenen Scheiben wurde die Dichte der GOI-Defekte untersucht.

Die Ergebnisse der Untersuchung sind in Figur 2 dargestellt. Jedem dargestellten Meßwert ist eine Ziffer vorangestellt, die den Durchmesser des gezogenen Einkristalls beschreibt. Die Ziffern 6, 8 und 12 stehen für einen Durchmesser von 150 mm, 200 mm und 300 mm. Der einer Ziffer nachfolgende Buchstabe (A bis E) bedeutet eine bestimmte thermische Abschirmung des Einkristalls. Defektdichten und Verweildauern sind in normierten Einheiten angegeben.

Es ist deutlich zu erkennen, daß die Defekt-Dichte von der Verweildauer des Einkristalls im genannten Temperaturbereich abhängt. Bei einer kurzen Verweildauer war die Defekt-Dichte sehr hoch und demzufolge die GOI-Ausbeute niedrig. Allerdings blieb die Größe der Defekte im wesentlichen unter 0,12 µm, so daß sich diese Scheiben als monitor-wafer und, nach einer Wärmebehandlung bei ca. 1100 °C in einer Wasserstoffatmosphäre, auch bestens als prime-wafer eigneten. Die niedrigsten Defekt-Dichten und höchsten GOI-Ausbeuten wurden bei Scheiben gefunden, die aus Einkristallen stammten, deren Verweildauer im Temperaturbereich von 900 bis 1050 °C länger als 150 min betragen hatte. Diese Scheiben eigneten sich bestens als prime-wafer.

## Patentansprüche

1. Verfahren zur Herstellung eines Einkristalls aus Silicium, wobei der wachsende Einkristall während einer bestimmten Verweildauer in einem bestimmten Temperaturbereich gehalten wird, **dadurch gekennzeichnet, daß** als Temperaturbereich der Bereich von 850 bis 1100 °C gewählt wird und die Verweildauer des wachsenden Einkristalls in dem gewählten Temperaturbereich größer als 250 min ist.

2. Verfahren nach Anspruch 1, **dadurch gekennzeichnet, daß** die Abkühlgeschwindigkeit des wachsenden Einkristalls durch einen Hitzeschild beeinflußt wird, der den wachsenden Einkristall umgibt, wobei der Hitzeschild zwischen einem unteren und einem oberen Rand in ringförmige Zonen untergliedert ist, und benachbarte Zonen sich in Bezug auf Wärmeleitung und Durchlässigkeit von Wärmestrahlung unterscheiden.

3. Verfahren nach Anspruch 1 oder Anspruch 2, **dadurch gekennzeichnet, daß** die Zone am unteren Rand des Hitzeschilds einen Emissions-Koeffizienten von 0,3 bis 0,9 und einen Wärmeleitungs-Koeffizienten von 0,02 bis 5 Wm⁻¹K⁻¹ aufweist.

4. Vorrichtung zur Herstellung eines Einkristalls aus Silicium mit einem, den wachsenden Einkristall umgebenden Hitzeschild, **dadurch gekennzeichnet, daß** der Hitzeschild zwischen einem unteren und einem oberen Rand in mindestens zwei ringförmige Zonen untergliedert ist, die von übereinander angeordneten Segmenten gebildet werden, wobei sich benachbarte Segmente in Bezug auf Wärmeleitfähigkeit und Durchlässigkeit von Wärmestrahlung alleine aufgrund ihrer Materialeigenschaft unterscheiden, und ein aktives Kühlen oder Erhitzen durch die Segmente selbst nicht vorgesehen ist.

5. Vorrichtung nach Anspruch 4, **dadurch gekennzeichnet, daß** die Zone am unteren Rand des Hitzeschilds einen Emissions-Koeffizienten von 0,3 bis 0,9 und einen Wärmeleitungs-Koeffizienten von 0,02 bis 5 Wm⁻¹K⁻¹ besitzt.

6. Vorrichtung nach Anspruch 4 oder Anspruch 5, **dadurch gekennzeichnet, daß** mindestens eine der Zonen durch eine Kühlvorrichtung kühlbar ist.

7. Vorrichtung nach Anspruch 4 oder Anspruch 5, **dadurch gekennzeichnet, daß** mindestens eine der Zonen durch eine Heizvorrichtung heizbar ist.

8. Vorrichtung nach einem der Ansprüche 4 bis 7, **dadurch gekennzeichnet, daß** die Gesamtzahl der Zonen 2 bis 5 ist.

9. Vorrichtung nach einem der Ansprüche 4 bis 7, **dadurch gekennzeichnet, daß** der Hitzeschild aus mindestens einem Werkstoff gefertigt ist, der aus einer Gruppe von Werkstoffen ausgewählt ist, die Graphit, Graphitfilz, Quarz, Silicium, CFC, Molybdän, Silber und schichtförmige Verbundstrukturen zweier oder mehrerer der genannten Werkstoffe umfaßt.

## Claims

1. Method for producing a silicon monocrystal, in which the growing monocrystal is kept for a specified dwell time in a specified temperature range, **characterized in that** the range from 850 to 1100°C is chosen as temperature range and the dwell time of the growing monocrystal in the chosen temperature range is greater than 250 min.

2. Method according to Claim 1, **characterized in that** the cooling rate of the growing monocrystal is influenced by a heat shield which surrounds the growing monocrystal, the heat shield being subdivided into annular zones between a lower rim and an upper rim and adjacent zones differing in regard to thermal conduction and transparency to heat radiation.

3. Method according to Claim 1 or Claim 2,
**characterized in that** the zone at the lower rim of the heat shield has an emission coefficient of 0.3 to 0.9 and a thermal conductivity of 0.02 to 5 Wm⁻¹ K⁻¹.

4. Device for producing a silicon monocrystal having a heat shield which surrounds the growing monocrystal, **characterized in that** the heat shield is subdivided into at least two annular zones between a lower rim and an upper rim, which zones are formed by segments disposed one above the other, adjacent segments differing in regard to thermal conductivity and transparency to heat radiation solely on account of their material property, and active cooling or heating not being provided by the segments themselves.

5. Device according to Claim 4, **characterized in that** the zone at the lower rim of the heat shield has an emission coefficient of 0.3 to 0.9 and a thermal conductivity of 0.02 to 5 Wm⁻¹K⁻¹.

6. Device according to Claim 4 or Claim 5,
**characterized in that** at least one of the zones can be cooled by a cooling device.

7. Device according to Claim 4 or Claim 5,
**characterized in that** at least one of the zones can be heated by a heating device.

8. Device according to any one of Claims 4 to 7, **characterized in that** the total number of zones is 2 to 5.

9. Device according to any one of Claims 4 to 7, **characterized in that** the heat shield is manufactured from at least one material which is chosen from the group of materials comprising graphite, graphite felt, quartz, silicon, CFC, molybdenum, silver and laminated composite structures of two or more of said materials.

## Revendications

1. Procédé de fabrication d'un monocristal en silicium, avec lequel le monocristal en croissance est maintenu dans une plage de température donnée pendant une durée de séjour donnée, **caractérisé en ce que** la plage de température choisie est la plage de 850 à 1100°C et que la durée de séjour du monocristal en croissance dans la plage de température choisie est supérieure à 250 minutes.

2. Procédé selon la revendication 1, **caractérisé en ce que** la vitesse de refroidissement du monocristal en croissance est influencée par un bouclier thermique qui entoure le monocristal en croissance, le bouclier thermique étant logé dans des zones annulaires entre un bord inférieur et un bord supérieur et les zones voisines se différenciant du point de vue de la conduction thermique et de la perméabilité au rayonnement thermique.

3. Procédé selon la revendication 1 ou la revendication 2, **caractérisé en ce que** la zone au niveau du bord inférieur du bouclier thermique présente un coefficient d'émission compris entre 0,3 et 0,9 et un coefficient de conduction thermique compris entre 0,02 et 5 Wm⁻¹K⁻¹.

4. Appareillage de fabrication d'un monocristal en silicium avec un bouclier thermique entourant le monocristal en croissance, **caractérisé en ce que** le bouclier thermique est logé dans au moins deux zones annulaires entre un bord inférieur et un bord supérieur qui sont formées par des segments superposés, les segments voisins se différenciant du point de vue de la conduction thermique et de la perméabilité au rayonnement thermique uniquement en raison des caractéristiques de leur matériau et un refroidissement ou un échauffement actif par les segments eux-mêmes n'étant pas prévu.

5. Appareillage selon la revendication 4, **caractérisé en ce que** la zone au niveau du bord inférieur du bouclier thermique présente un coefficient d'émission compris entre 0,3 et 0,9 et un coefficient de conduction thermique compris entre 0,02 et 5 Wm⁻¹K⁻¹.

6. Appareillage selon la revendication 4 ou la revendication 5, **caractérisé en ce qu'**au moins l'une des zones peut être refroidie par un dispositif de refroidissement.

7. Appareillage selon la revendication 4 ou la revendication 5, **caractérisé en ce qu'**au moins l'une des zones peut être échauffée par un dispositif de chauffage.

8. Appareillage selon l'une des revendications 4 à 7, **caractérisé en ce que** le nombre total des zones est compris entre 2 et 5.

9. Appareillage selon l'une des revendications 4 à 7, **caractérisé en ce que** le bouclier thermique est fabriqué dans au moins un matériau qui est choisi dans un groupe de matériaux qui comprend le graphite, le feutre graphité, le quartz, le silicium, le CFC, le molybdène, l'argent et les structures composites en forme de couches de deux ou de plusieurs des matériaux mentionnés.
